# EUROPEAN PATENT APPLICATION

(11) **EP 4 671 660 A1**
(43) Date of publication of application: **31.12.2025**
(21) Application number: 25184913.9
(22) Date of filing: 24.06.2025
(51) Int. Cl.: F28D 15/02, F28F 1/32

(54) **AIR-COOLED HEAT SINK**

(30) Priority: 26.06.2024 TW 113206743 U
(71) Applicant: Cooler Master Technology Inc., Tapei City 114065 (TW)
(72) Inventor: CHENG, Jen-Chih, Taipei City 114065 (TW)
(74) Representative: Grünecker Patent- und Rechtsanwälte PartG mbB

(57) **Abstract**

An air-cooled heat sink includes a heat-conducting base, a plurality of heat pipes disposed on the heat-conducting base, a looped heat-conducting element disposed on the heat-conducting base that includes two first heat transfer sections, and at least one fin having at least one perforation and two clearance slots. Each of the heat pipes extends through a corresponding perforation, and each first heat transfer section is arranged in a corresponding clearance slot, such that the heat-conducting element is spaced apart from the heat pipe.

## Description

### TECHNICAL FIELD

The present disclosure relates to an air-cooled heat sink, and more particularly to an air-cooled heat sink incorporating a looped heat-conducting element.

### BACKGROUND

Electronic devices and mechanical machines generate tremendous amounts of heat during operation. Manufacturers commonly employ air-cooled heat sinks to dissipate the heat. The air-cooled heat sinks often include heat pipes that transfer heat via the phase change of a working fluid. Specifically, the working fluid inside the heat pipe absorbs heat at the evaporation end, vaporizes, and then moves toward the condensation end due to vapor pressure. At the condensation end, the vapor releases heat, condenses, and turns back into liquid. The condensed liquid then returns to the evaporation end via a capillary structure, enabling a continuous cooling cycle.

With the development of technology, the performance of electronic devices is progressively enhanced, resulting in greater heat generation during operation. However, traditional air-cooled heat sinks are no longer effectively in dissipating increased heat efficiently. Insufficient thermal dissipation can lead to overheating, potential damaging electronic components. Therefore, improving the heat dissipation efficiency of air-cooled heat sinks has emerged as an important challenge in addressing the thermal management needs of modern electronic devices.

### SUMMARY

In general terms, this disclosure is directed to an air-cooled heat sink. In some embodiment, and by non-limiting example, the present disclosure provides an air-cooled heat sink designed to enhance heat dissipation performance to satisfy the greater thermal management needs of modern electronic devices.

_The invention is as defined in the appended claims. An aspect of the present disclosure provides an air-cooled heat sink. The air-cooled heat sink includes a heat-conducting base, a plurality of heat pipes disposed on the heat-conducting base, a looped heat-conducting element disposed on the heat-conducting base that includes two first heat transfer sections, and at least one fin having at least one perforation and two clearance slots, wherein each of the heat pipes extends through a corresponding perforation, and each first heat transfer section is arranged in a corresponding clearance slot, such that the heat-conducting element is spaced apart from the heat pipe.

In one embodiment, the looped heat-conducting element further comprises a heat absorption section and a heat dissipation section, the heat absorption section being connected to the two first heat transfer sections at a lower position, and the heat dissipation section being connected to the two first heat transfer sections at an upper position to form a closed loop.

In one embodiment, the heat absorption section is thermally coupled to the heat pipe.

In one embodiment, the heat pipe comprises a second heat transfer section and two third heat transfer sections, the two third heat transfer sections being respectively coupled to opposite ends of the second heat transfer section and extend in a same direction, and the looped heat-conducting element is at least partially disposed between the two third heat transfer sections.

In one embodiment, the looped heat-conducting element includes a plurality of circulation paths that are fluidly isolated from one another.

In one embodiment, the looped heat-conducting element includes a hollow heat pipe.

In one embodiment, the looped heat-conducting element includes a heat pipe with an internal capillary structure.

Another aspect of the present disclosure provides an air-cooled heat sink. The air-cooled hear sink includes a heat-conducting base, a plurality of heat pipes disposed on the heat-conducting base, a looped heat-conducting element disposed on the heat-conducting base, the looped heat-conducting element having a heat-conducting shell and a heat transfer pipe that includes two first heat transfer sections, and at least one fin having at least one perforation and two clearance slots, wherein each of the heat pipes extends through a corresponding perforation, and each first heat transfer section is arranged in a corresponding clearance slot, such that the heat-conducting element is spaced apart from the heat pipe.

In one embodiment, the heat transfer pipe further includes a heat dissipation section that is positioned above the heat-conducting shell, opposite ends of the heat dissipation section being respectively connected to the two first heat transfer sections.

In one embodiment, the heat pipe comprises a second heat transfer section and two third heat transfer sections, the two third heat transfer sections being respectively coupled to opposite ends of the second heat transfer section and extend in a same direction, and the looped heat-conducting element is at least partially disposed between the two third heat transfer sections.

In one embodiment, the heat-conducting shell includes a first shell body and a second shell body, the first shell body being coupled to the first heat transfer sections.

In one embodiment, the first shell body is thermally coupled to the first heat transfer section and includes a first oblique flow channel, a plurality of second oblique flow channels arranged in parallel with the first oblique flow channel, and a return flow channel, and the second shell body encloses the first oblique flow channel, the second oblique flow channels, and the return flow channel.

In one embodiment, the heat transfer pipe includes a plurality of parallel heat dissipation channels, opposing ends of a first outermost heat dissipation channel being respectively connected to a flow channel inlet and one of a plurality of communication ports, opposing ends of a second outermost heat dissipation channel being respectively connected to a flow channel outlet and another one of the communication ports, and opposing ends of each of remaining heat dissipation channels are respectively connected to two of the communication ports that are in fluid communication with each other.

In one embodiment, the heat dissipation channels, the first oblique flow channel, the second oblique flow channels, and the return flow channel together form a single circulation path.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is a perspective view of an air-cooled heat sink in accordance with one embodiment of the present disclosure.
FIG. 2 is a cross-sectional view of the air-cooled heat sink shown in FIG. 1.
FIG. 3 is a partially enlarged perspective view of the air-cooled heat sink shown in FIG. 1.
FIG. 4 is another partially enlarged perspective view of the air-cooled heat sink shown in FIG. 1, with an inner surface of the looped heat-conducting element omitted for clarity.
FIG. 5 is a top view of a heat absorption section of the air-cooled heat sink shown in FIG. 1.
FIG. 6 is a top view of a heat dissipation section of the air-cooled heat sink shown in FIG. 1.
FIG. 7 is a cross-sectional view illustrating the flow of a cooling fluid through the looped heat-conducting element in the air-cooled heat sink shown in FIG. 1.
FIG. 8 is a perspective view of an air-cooled heat sink in accordance with one embodiment of the present disclosure.
FIG. 9 is a cross-sectional view of the air-cooled heat sink shown in FIG. 8.
FIG. 10 is a partially enlarged perspective view of the air-cooled heat sink shown in FIG. 8.
FIG. 11 is another partially enlarged perspective view of the air-cooled heat sink shown in FIG. 8, with an inner surface of the heat pipe omitted for clarity.
FIG. 12 is still another partially enlarged perspective view of the air-cooled heat sink shown in FIG. 8, also with an inner surface of the heat pipe omitted for clarity.
FIG. 13 is a top view of a heat-conducting shell of the air-cooled heat sink shown in FIG. 8.
FIG. 14 is a top view of a heat dissipation section of the air-cooled heat sink shown in FIG. 8.
FIG. 15 is a cross-sectional view illustrating the flow of a cooling fluid through the looped heat-conducting element in the air-cooled heat sink shown in FIG. 8.
FIG. 16 is a top view illustrating the flow of a cooling fluid through the looped heat-conducting element in the air-cooled heat sink shown in FIG. 8.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

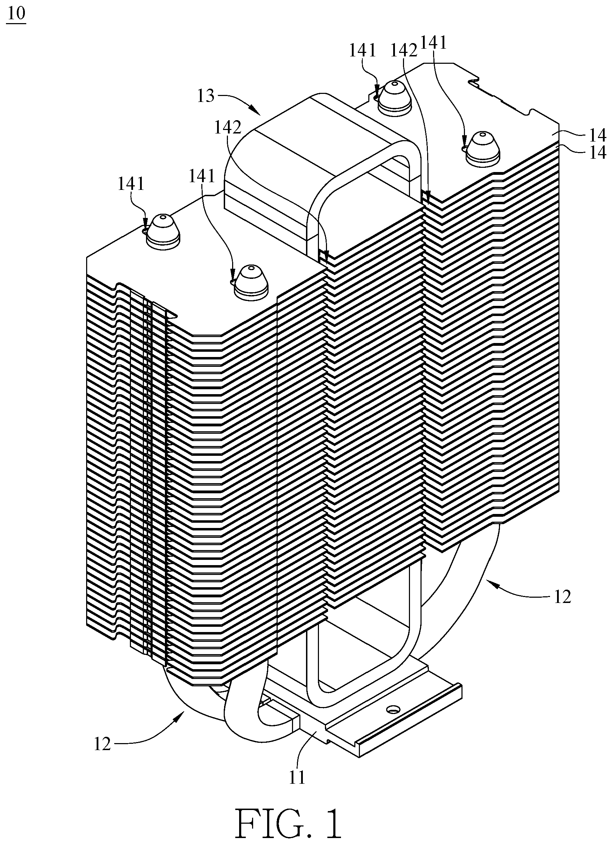

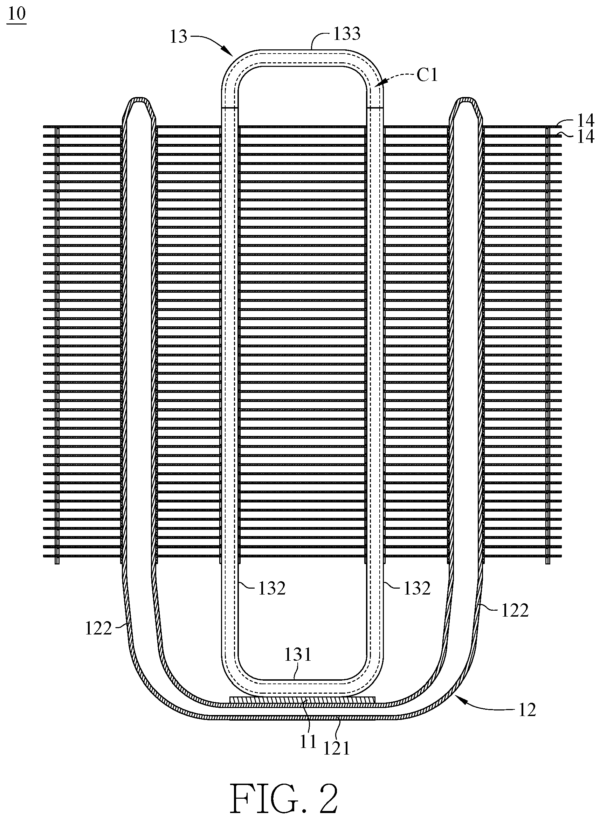

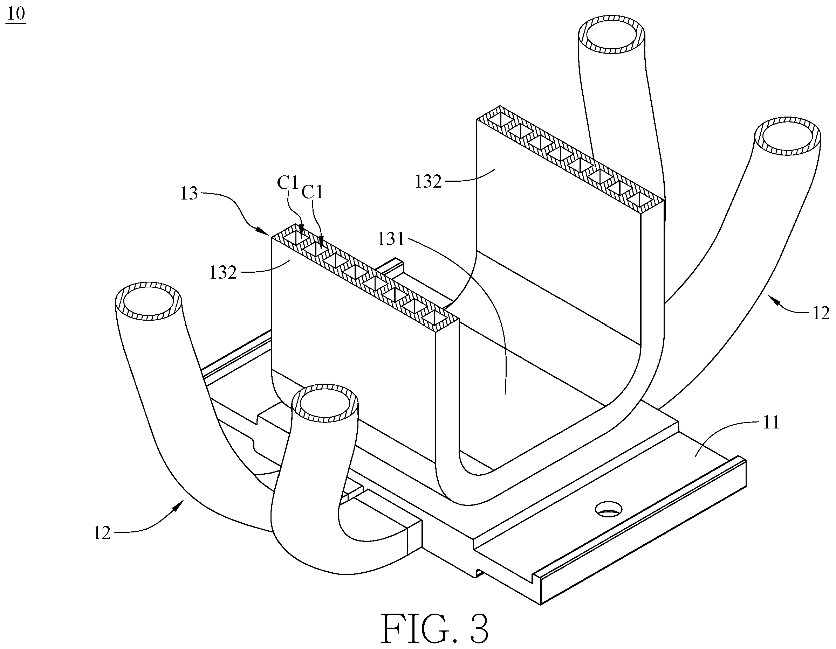

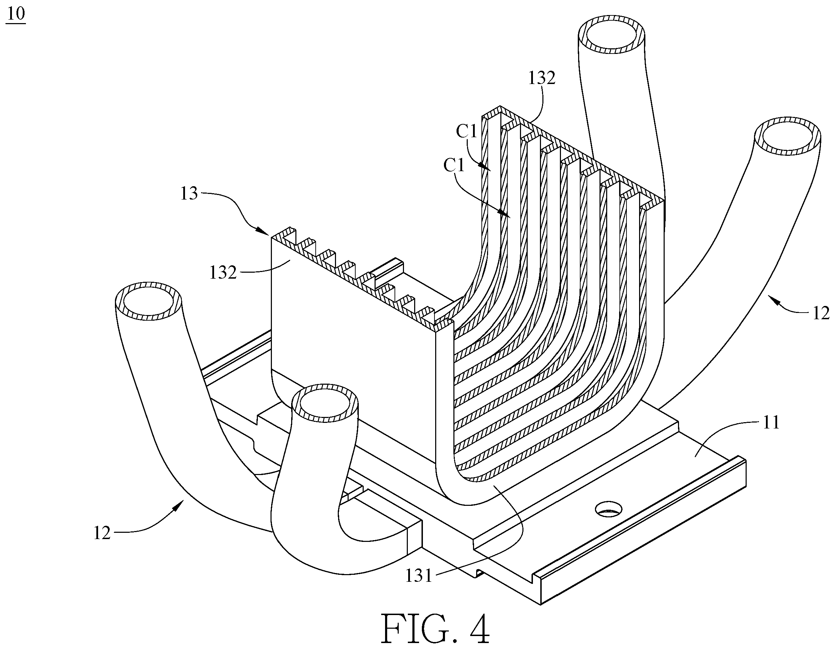

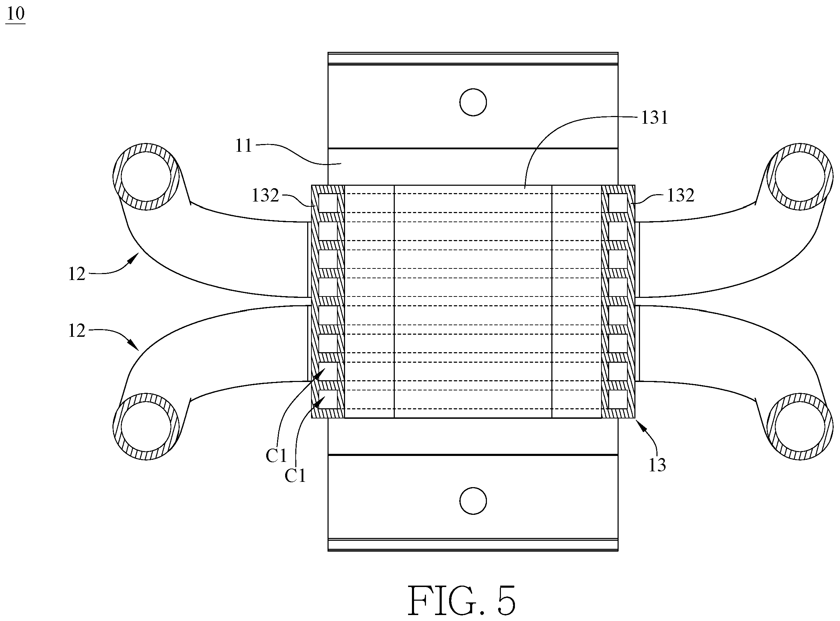

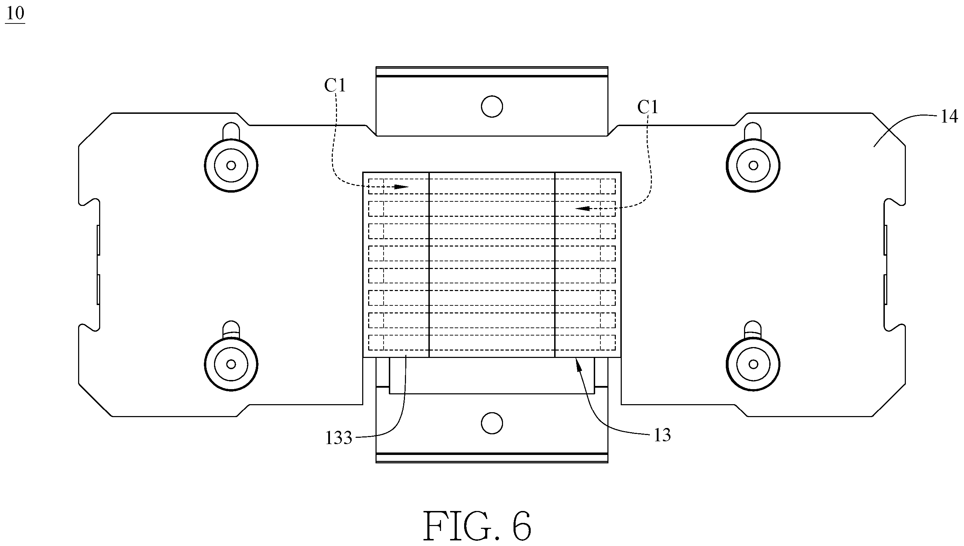

Referring to FIGS. 1-6. FIG. 1 is a perspective view of an air-cooled heat sink in accordance with one embodiment of the present disclosure. FIG. 2 is a cross-sectional view of the air-cooled heat sink shown in FIG. 1. FIG. 3 is a partially enlarged perspective view of the air-cooled heat sink shown in FIG. 1. FIG. 4 is another partially enlarged perspective view of the air-cooled heat sink shown in FIG. 1, with an inner surface of the looped heat-conducting element omitted for clarity. FIG. 5 is a top view of a heat absorption section of the air-cooled heat sink shown in FIG. 1. FIG. 6 is a top view of a heat dissipation section of the air-cooled heat sink shown in FIG. 1.

As an example illustrated in FIG. 1, the air-cooled heat sink 10 is configured for thermal coupling to a heat source (not shown). For example, the air-cooled heat sink 10 can be coupled to the heat source via either direct thermal contact or another thermally conductive medium.

In one embodiment, the air-cooled heat sink 10 includes a heat-conducting base 11, a plurality of heat pipes 12, a looped heat-conducting element 13, and a plurality of fins 14. However, the embodiment is not limited thereto. In other embodiments, the air-cooled heat sink 10 could include a single heat pipe and a single fin, among other components. The heat-conducting base 11 is made of a material such as aluminum, copper, or any other suitable material.

In one embodiment, the heat pipes 12 are disposed on the heat-conducting base 11 and configured to contain a first cooling fluid (not shown). In another embodiment, the looped heat-conducting element 13 may be a pulsating heat pipe (PHP) and disposed on the heat-conducting base 11. The pulsating heat pipe typically includes a plurality of hollow U-shaped tubes connected in series and lacks capillary wick structure. This arrangement enhances heat dissipation from the heat source by employing the thermosiphon effect of the pulsating heat pipe to improve cooling efficiency.

However, the embodiment is not limited thereto. In other embodiments, the looped heat-conducting element 13 can be a thermosiphon-type heat pipe. In thermal recycling, the thermosiphon refers to a mechanism in which the liquid cooling fluid partially vaporizes upon heating, forming a gas-liquid mixture, with the density difference between the liquid and vapor phases acting as the driving force for thermal cycling. Additionally, the thermosiphon-type heat pipe could include a capillary structure, allowing the cooling fluid to flow through the first heat transfer sections and the heat dissipation section and then return to the heat absorption section via capillary action.

In one embodiment, each of the heat pipes 12 includes a second heat transfer section 121 and two third heat transfer sections 122. As an example illustrated in FIG. 2, the third heat transfer sections 122 are connected to opposite ends of the second heat transfer section 121 via bent portions and protrude in the same direction. In other words, the heat pipes 12 are, for example, U-shaped, which further facilitates heat dissipation from the heat source. The looped heat-conducting element 13 is at least partially disposed between the two third heat transfer sections 122.

In one embodiment, the looped heat-conducting element 13 includes a plurality of circulation paths C1 and is configured to contain a second cooling fluid (not shown). These circulation paths C1 are not interconnected with each other but operate independently from one another as separate channels. Furthermore, in some embodiments, the first and second cooling fluids can be water or refrigerant.

In one embodiment, the looped heat-conducting element 13 includes a heat absorption section 131, two first heat transfer sections 132, and a heat dissipation section 133. As an example illustrated in FIG. 2, the heat absorption section 131 is connected to the two first heat transfer sections 132 at a lower position, and the heat dissipation section 133 is connected to the two first heat transfer sections 132 at an upper position, forming a closed loop such as an annular or ring-like structure. The heat absorption section 131 is thermally connected to at least one of the heat pipes 12 via the heat-conducting base 11. In this embodiment, the heat absorption section 131 is welded to the heat-conducting base 11, configured to absorb heat from the heat source and subsequently transfer it to the first heat transfer sections 132 and the heat dissipation section 133 for thermal dissipation. However, the embodiment is not limited thereto. In other embodiments, the heat absorption section 131 may be connected to the heat-conducting base 11 by other joining methods such as brazing, soldering, mechanical fastening, or the use of thermally conductive adhesive.

In one embodiment, the fins 14 are arranged side by side. Each fin 14 includes a plurality of perforations 141 and two clearance slots 142. However, the embodiment is not limited thereto. In other embodiments, the fin may include a single perforation. As an example illustrated in FIG. 1, the perforations 141 are formed on opposite sides of each fin 14, and the two clearance slots 142 are formed at a central portion of the fin 14. However, the embodiment is not limited thereto. In other embodiments, the perforations 141 and the clearance slots 142 can be positioned at other suitable locations.

In one embodiment, the third heat transfer sections 122 of the heat pipes 12 extend through respective perforations 141. The two first heat transfer sections 132 of the looped heat-conducting element 13 are disposed in the corresponding clearance slots 142, ensuring that the heat pipes 12 and the looped heat-conducting element 13 are separated from one another. Accordingly, the heat absorbed from the heat source by the second heat transfer sections 121 of the heat pipes 12 and the heat absorption section 131 of the looped heat-conducting element 13 can be transferred to the fins 14. Therefore, the fins 14 facilitate the heat dissipation via airflow, further enhancing the heat dissipation efficiency of both the heat pipes 12 and the looped heat-conducting element 13.

According to the described embodiments, the heat pipes 12 and the looped heat-conducting element 13 work together to effectively manage heat dissipation from the heat source. This collaborative design significantly enhances the overall heat dissipation efficiency of the air-cooled heat sink 10, allowing it to satisfy thermal management requirements more effectively.

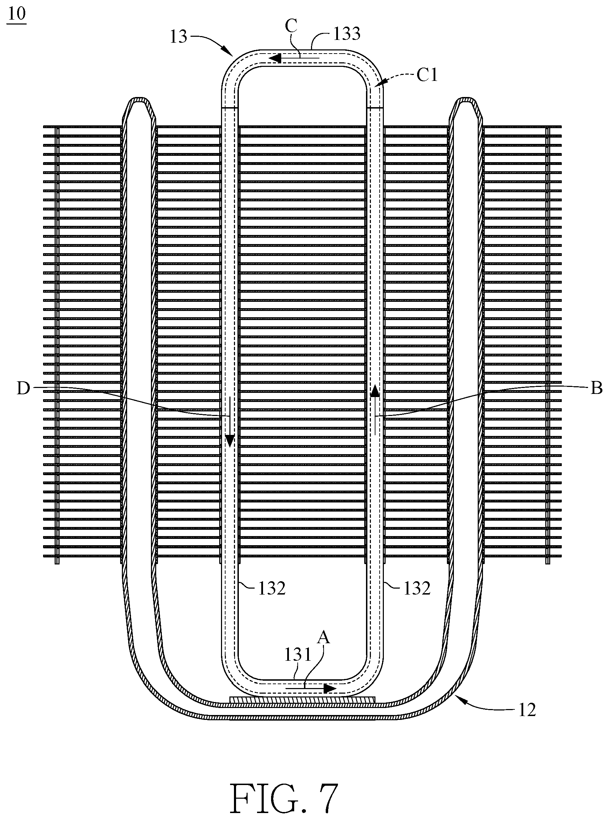

Referring to FIG. 7. FIG. 7 is a cross-sectional view illustrating the flow of a cooling fluid through the looped heat-conducting element in the air-cooled heat sink shown in FIG. 1.

In one embodiment, when the heat absorption section 131 of the looped heat-conducting element 13 absorbs heat from the heat source, the heat is transferred to the second cooling fluid within the looped heat-conducting element 13. The heated second cooling fluid flows through the heat absorption section 131 in direction A. Subsequently, it flows from the heat absorption section 131 into one of the two first heat transfer sections 132 and continues flowing along direction B. Throughout the process, the second cooling fluid dissipates heat through the fins 14.

Next, the second cooling fluid flows from the first heat transfer section 132 into the heat dissipation section 133, where it continues flowing in direction C. Subsequently, the second cooling fluid proceeds from the heat dissipation section 133 into the other first heat transfer section 132 and flows along direction D. Finally, the second cooling fluid returns to the heat absorption section 131, completing one thermal cycle. Accordingly, the looped heat-conducting element 13 facilitates heat dissipation from the heat source.

Additionally, as the heat pipes 12 also absorb heat from the heat source, the absorbed heat is transferred to the first cooling fluid within the heat pipes 12. The first cooling fluid then circulates through the heat pipes 12 to further enhance the heat dissipation from the heat source.

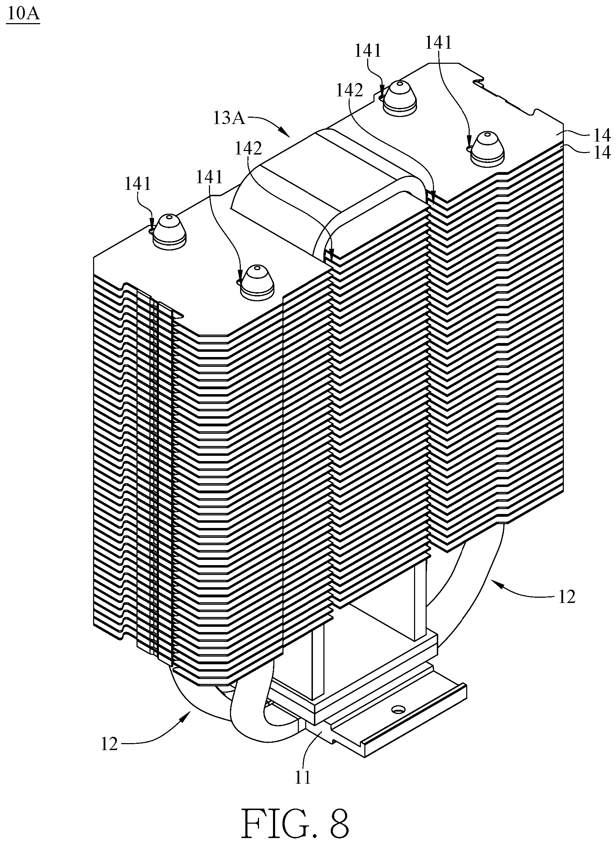

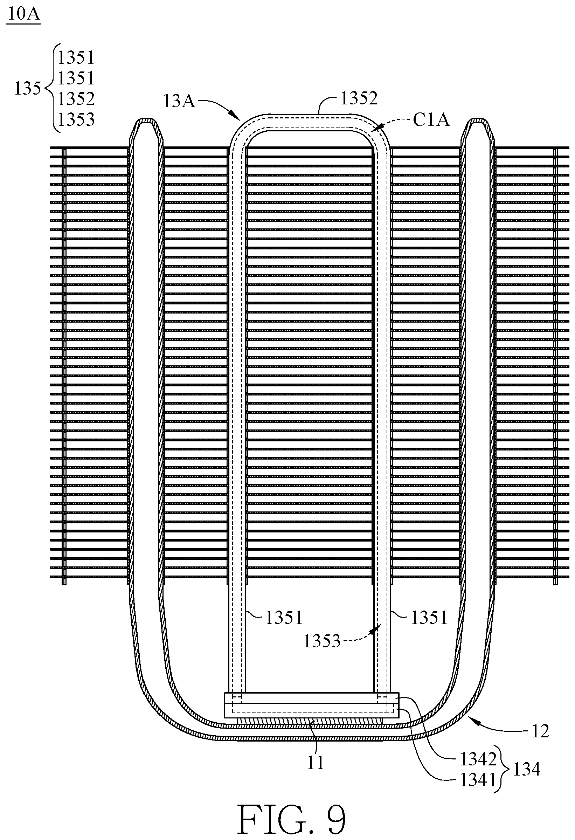

Referring to FIGS. 8-9. FIG. 8 is a perspective view of an air-cooled heat sink in accordance with one embodiment of the present disclosure. FIG. 9 is a cross-sectional view of the air-cooled heat sink shown in FIG. 8. The air-cooled heat sink 10A is similar to the air-cooled heat sink 10 in FIG. 1. Therefore, only the differences will be described in detail below, and the similarities will be omitted for brevity.

In one embodiment, the looped heat-conducting element 13A includes only a single circulation path C1A. The looped heat-conducting element 13A includes a heat-conducting shell 134 and a heat transfer pipe 135. The heat-conducting shell 134 is thermally coupled to the heat pipes 12, and the heat transfer pipe 135 is in fluid communication with the heat-conducting shell 134. The heat transfer pipe 135 includes two first heat transfer sections 1351 and one heat dissipation section 1352. The opposite ends of the heat dissipation section 1352 are connected respectively to the ends of the two first heat transfer sections 1351 that are further away from the heat-conducting shell 134. For example, the heat transfer pipe 135 is U-shaped. In this embodiment, the heat-conducting shell 134 is welded to the heat-conducting base 11 and is thermally coupled to the first heat transfer sections 1351. However, the embodiment is not limited thereto. In other embodiments, the heat-conducting shell 134 can be connected to the heat-conducting base 11 by other joining methods such as brazing, soldering, mechanical fastening, or applying thermally conductive adhesive. In another embodiment, the heat-conducting shell 134 and the heat-conducting base 11 can also be integrally formed as a single piece.

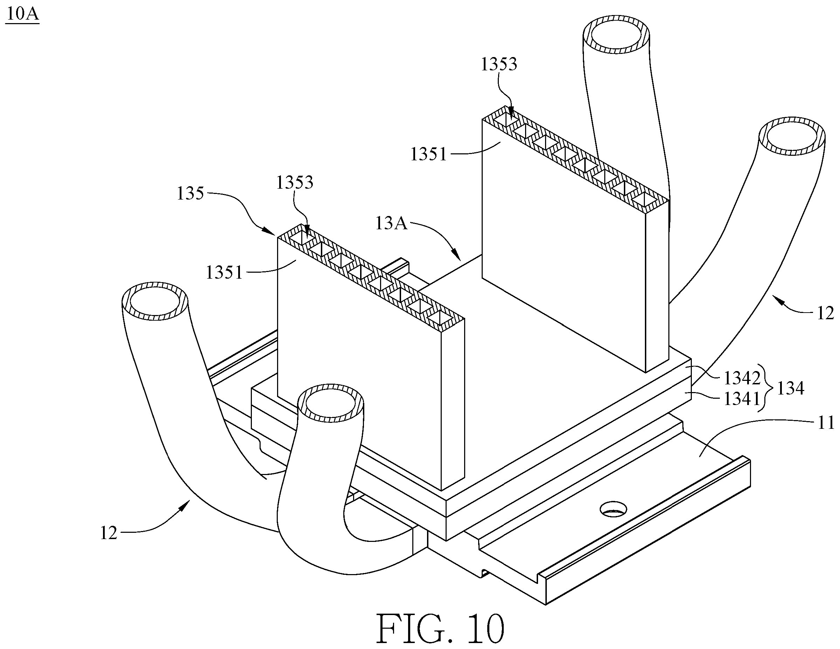

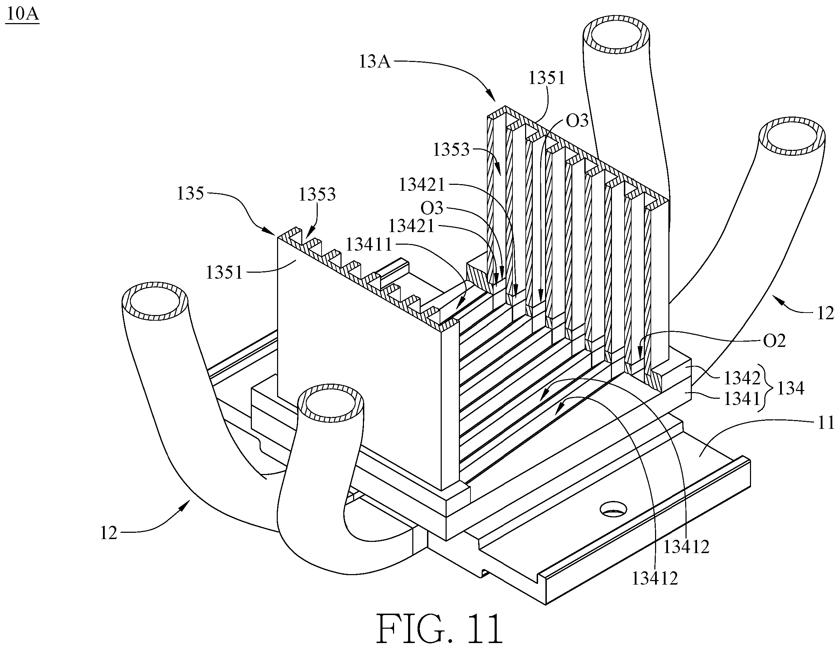

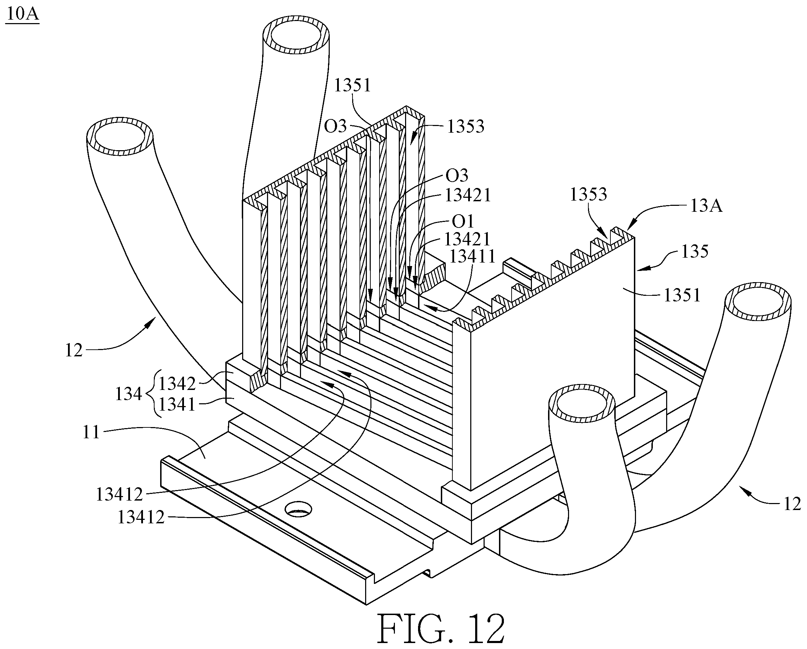

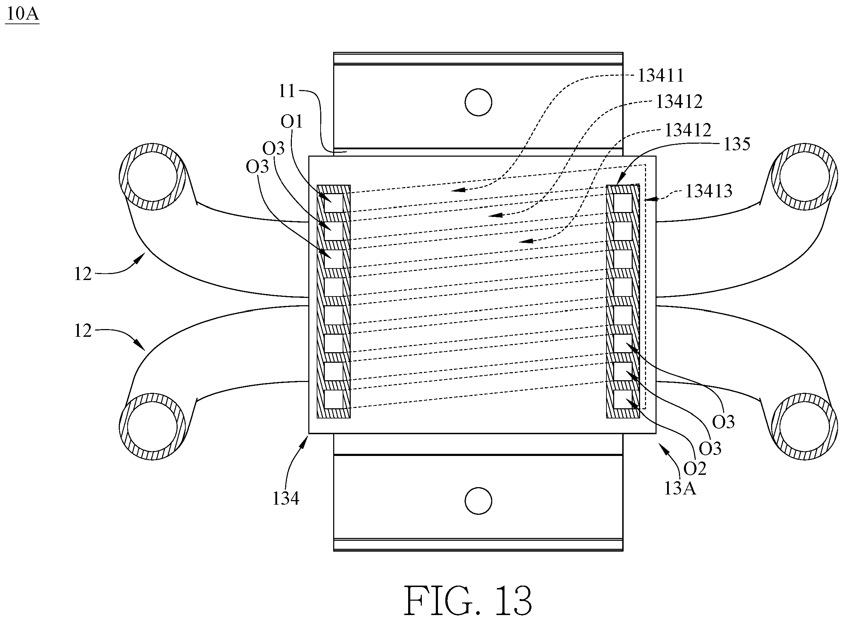

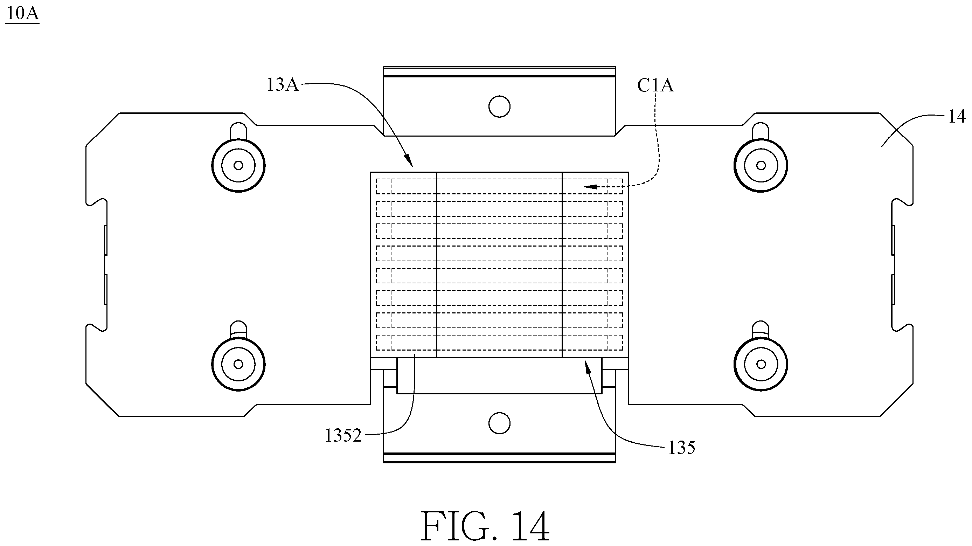

Referring to FIGS. 10-14. FIG. 10 is a partially enlarged perspective view of the air-cooled heat sink shown in FIG. 8. FIG. 11 is another partially enlarged perspective view of the air-cooled heat sink shown in FIG. 8, with an inner surface of the heat pipe omitted for clarity. FIG. 12 is still another partially enlarged perspective view of the air-cooled heat sink shown in FIG. 8, also with an inner surface of the heat pipe omitted for clarity. FIG. 13 is a top view of a heat-conducting shell of the air-cooled heat sink shown in FIG. 8. FIG. 14 is a top view of a heat dissipation section of the air-cooled heat sink shown in FIG. 8.

In one embodiment, the heat-conducting shell 134 includes a first shell body 1341 and a second shell body 1342. The first shell body 1341 is thermally coupled to the first heat transfer section 1351 and includes a first oblique flow channel 13411, a plurality of second oblique flow channels 13412, and a return flow channel 13413. The first oblique flow channel 13411 and the second oblique flow channels 13412 are arranged in parallel. The second shell body 1342 encloses the first oblique flow channel 13411, the second oblique flow channels 13412, and the return flow channel 13413. The second shell body 1342 also includes a plurality of through holes 13421 that are respectively in fluid communication with the first oblique flow channel 13411, the second oblique flow channels 13412, and the return flow channel 13413.

In one embodiment, the heat transfer pipe 135 includes a plurality of heat dissipation channels 1353. The heat dissipation channels 1353 are arranged side-by-side and are individually isolated from one another. Opposing ends of a first outermost heat dissipation channel 1353 are respectively connected to a flow channel inlet O1 and one of a plurality of communication ports O3. Opposing ends of a second outermost heat dissipation channel 1353 are respectively connected to a flow channel outlet O2 and another one of the communication ports O3. Opposing ends of each of the remaining heat dissipation channels 1353 are respectively connected to two of the communication ports O3 that are in fluid communication with one another.

In one embodiment, the flow channel inlet O1, the flow channel outlet O2, and the communication ports O3 are each in fluid communication with a corresponding heat dissipation channel 1353 via the through holes 13421. The flow channel inlet O1 is in fluid communication with one end of the first oblique flow channel 13411, and the other end of the first oblique flow channel 13411 is in communication with one end of the return flow channel 13413. The opposite end of the return flow channel 13413 is in fluid communication with the flow channel outlet O2. The communication ports O3 are in fluid communication with the respective second oblique flow channels 13412. Accordingly, the heat dissipation channels 1353, the first oblique flow channel 13411, the second oblique flow channels 13412, and the return flow channel 13413 together form the circulation path C1A. However, the embodiment is not limited thereto. In other embodiments, the positions of the flow channel inlet and outlet may be reversed.

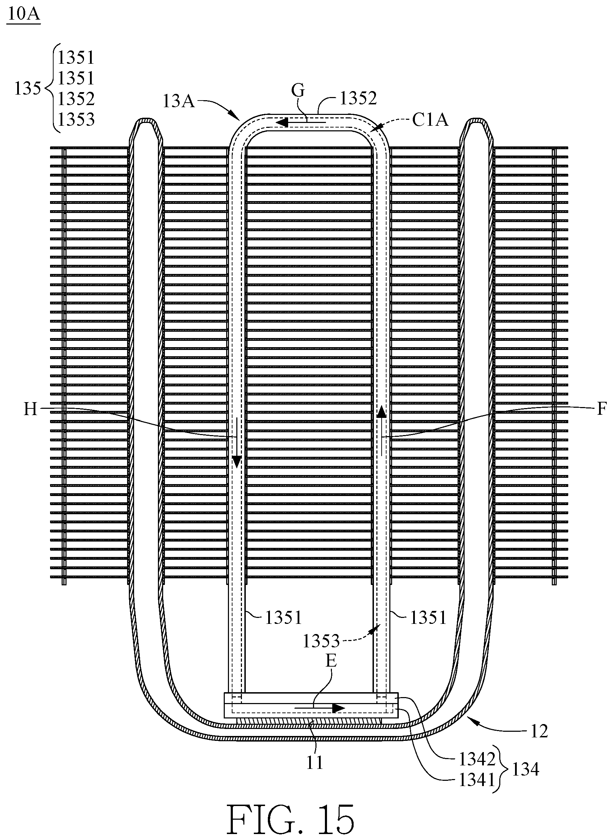

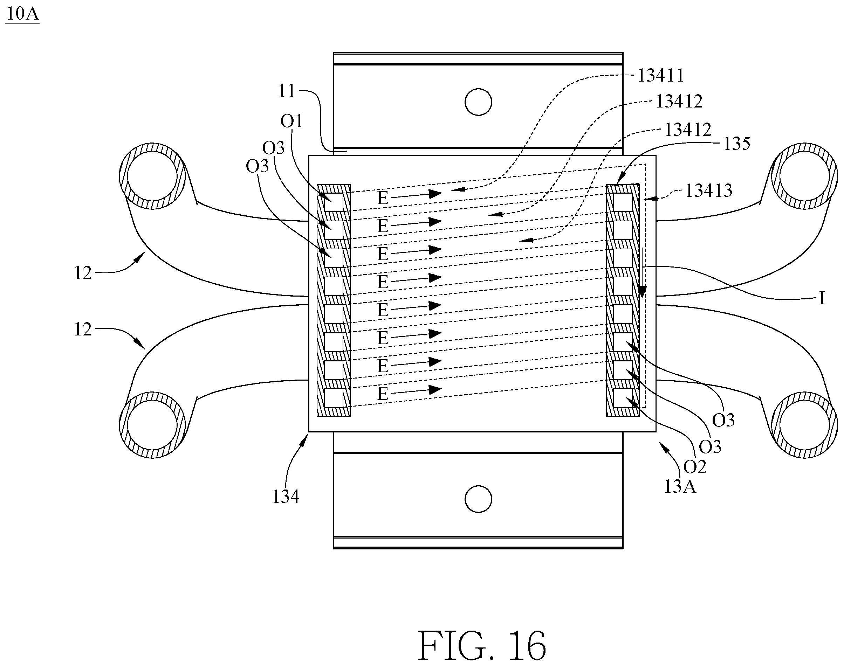

Referring to FIGS. 15-16. FIG. 15 is a cross-sectional view illustrating the flow of a cooling fluid through the looped heat-conducting element in the air-cooled heat sink shown in FIG. 8. FIG. 16 is a top view illustrating the flow of a cooling fluid through the looped heat-conducting element in the air-cooled heat sink shown in FIG. 8.

In one embodiment, when the first shell body 1341 of the heat-conducting element 13A absorbs heat from the heat source, it transfers the heat to the second cooling fluid within the heat-conducting element 13A. The heated second cooling fluid flows through the second oblique flow channels 13412 in the first shell body 1341 along the direction of arrow E. Subsequently, the heated second cooling fluid enters one of the two first heat transfer sections 1351 and continues to flow in direction F. Throughout the process, the heated second cooling fluid dissipates heat with the aid of the fins 14.

Next, the second cooling fluid flows from the first heat transfer section 1351 into the heat dissipation section 1352 and moves along direction G. It then flows into the other of the two first heat transfer sections 1351 and continues flowing along direction H. Subsequently, the cooling fluid enters the first oblique flow channel 13411 and flows in direction E. Then, the second cooling fluid moves into the return flow channel 13413 along direction I. Finally, the fluid returns to one of the first heat transfer sections 1351, completing the flow cycle and reentering the second oblique flow channels 13412 to initiate the next cooling cycle. Accordingly, the heat-conducting element 13A continuously dissipates heat from the heat source.

Additionally, as the heat pipes 12 also absorb heat from the heat source, the absorbed heat is transferred to the first cooling fluid within the heat pipes 12. The first cooling fluid circulates inside the heat pipes 12, further enhancing the heat dissipation for the heat source.

According to the described embodiment, the air-cooled heat sink 10A incorporates both the heat pipes 12 and the heat-conducting element 13A. This dual-path heat dissipation design enables the air-cooled heat sink 10A to transfer and dissipate heat more efficiently via both the heat pipes and the heat-conducting element 13A. Accordingly, the overall thermal dissipation efficiency is significantly improved, thereby enhancing the cooling performance of the heat sink and allowing it to meet higher thermal management requirements.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. An air-cooled heat sink (10), comprising:
a heat-conducting base (11);
a plurality of heat pipes (12) disposed on the heat-conducting base (11);
a looped heat-conducting element (13) disposed on the heat-conducting base (11) that includes two first heat transfer sections (132); and
at least one fin (14) having at least one perforation (141) and two clearance slots (142), wherein each of the heat pipes (12) extends through a corresponding perforation (141), and each first heat transfer section (132) is arranged in a corresponding clearance slot (142), such that the heat-conducting element (13) is spaced apart from the heat pipe (12).

2. The air-cooled heat sink (10) of claim 1, wherein the looped heat-conducting element (13) further comprises a heat absorption section (131) and a heat dissipation section (133), the heat absorption section (131) being connected to the two first heat transfer sections (132) at a lower position, and the heat dissipation section (133) being connected to the two first heat transfer sections (132) at an upper position to form a closed loop.

3. The air-cooled heat sink (10) of claim 2, wherein the heat absorption section (131) is thermally coupled to the heat pipe (12).

4. The air-cooled heat sink (10) of one of claims 1 to 3, wherein the heat pipe (12) comprises a second heat transfer section (121) and two third heat transfer sections (122), the two third heat transfer sections (122) being respectively coupled to opposite ends of the second heat transfer section (121) and extend in a same direction, and the looped heat-conducting element (13) is at least partially disposed between the two third heat transfer sections (122).

5. The air-cooled heat sink (10) of one of claims 1 to 4, wherein the looped heat-conducting element (13) includes a plurality of circulation paths (C1) that are fluidly isolated from one another.

6. The air-cooled heat sink (10) of one of claims 1 to 5, wherein the looped heat-conducting element (13) includes a hollow heat pipe.

7. The air-cooled heat sink (10) of claims 1 to 5, wherein the looped heat-conducting element (13) includes a heat pipe with an internal capillary structure.

8. An air-cooled heat sink (10), comprising:
a heat-conducting base (11);
a plurality of heat pipes (12) disposed on the heat-conducting base (11);
a looped heat-conducting element (13A) disposed on the heat-conducting base (11), the looped heat-conducting element (13A) having a heat-conducting shell (134) and a heat transfer pipe (135) that includes two first heat transfer sections (1351); and
at least one fin (14) having at least one perforation (141) and two clearance slots (142), wherein each of the heat pipes (12) extends through a corresponding perforation (141), and each first heat transfer section (1351) is arranged in a corresponding clearance slot (142), such that the heat-conducting element (13A) is spaced apart from the heat pipe (12).

9. The air-cooled heat sink (10) of claim 8, wherein the heat transfer pipe (135) further includes a heat dissipation section (1352) that is positioned above the heat-conducting shell (134), opposite ends of the heat dissipation section (1352) being respectively connected to the two first heat transfer sections (1351).

10. The air-cooled heat sink (10) of claim 8 or 9, wherein the heat pipe (12) comprises a second heat transfer section (121) and two third heat transfer sections (122), the two third heat transfer sections (122) being respectively coupled to opposite ends of the second heat transfer section (121) and extend in a same direction, and the looped heat-conducting element (13A) is at least partially disposed between the two third heat transfer sections (122).

11. The air-cooled heat sink (10) of one of claims 8 to 10, wherein the heat-conducting shell (134) includes a first shell body (1341) and a second shell body (1342), the first shell body (1341) being coupled to the first heat transfer sections (1351).

12. The air-cooled heat sink (10) of claim 11, wherein the first shell body (1341) is thermally coupled to the first heat transfer section (1351) and includes a first oblique flow channel (13411), a plurality of second oblique flow channels (13412) arranged in parallel with the first oblique flow channel (13411), and a return flow channel (13413), and the second shell body (1342) encloses the first oblique flow channel (13411), the second oblique flow channels (13412), and the return flow channel (13413).

13. The air-cooled heat sink (10) of one of claims 8 to 12, wherein the heat transfer pipe (135) includes a plurality of parallel heat dissipation channels (1353), opposing ends of a first outermost heat dissipation channel (1353) being respectively connected to a flow channel inlet (O1) and one of a plurality of communication ports (O3), opposing ends of a second outermost heat dissipation channel (1353) being respectively connected to a flow channel outlet (O2) and another one of the communication ports (O3), and opposing ends of each of remaining heat dissipation channels (1353) are respectively connected to two of the communication ports (O3) that are in fluid communication with each other.

14. The air-cooled heat sink (10) of claim 13, wherein the heat dissipation channels (1353), the first oblique flow channel (13411), the second oblique flow channels (13412), and the return flow channel (13413) together form a single circulation path (C1A).

15. The air-cooled heat sink (10) of one of claims 8 to 14, wherein the at least one heat pipe (12) is a hollow heat pipe.

16. The air-cooled heat sink (10) of one of claims 8 to 14, wherein the at least one heat pipe (12) includes an internal capillary structure.
